# EUROPEAN PATENT SPECIFICATION

(11) **EP 2 849 550 B1**
(45) Date of publication and mention of the grant of the patent: **06.09.2017**
(21) Application number: 13184694.1
(22) Date of filing: 17.09.2013
(51) Int. Cl.: H05K 7/14, F16C 1/22

(54) **Adjustment device for cable management arm**
Anpassungsvorrichtung für Kabelführungsarm
Dispositif d'ajustement pour bras de gestion de câble

(43) Date of publication of application: 18.03.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Chen, Yao-Tsung, Kaohsiung City (TW); Wang, Chun-Chiang, Kaohsiung City (TW)
(74) Representative: Viering, Jentschura & Partner mbB Patent- und Rechtsanwälte

(56) References cited:
- Anonymous: "Cable Management Arms | The Server Rack FAQ", , 22 April 2012 (2012-04-22), XP055102233, Retrieved from the Internet: URL:http://web.archive.org/web/20120422173 638/http://www.server-racks.com/cable-mana gement-arms.html [retrieved on 2014-02-14]
- Sun Microsystems: "Cable Management Arm Installation Note", , 31 March 2005 (2005-03-31), pages 1-17, XP055102189, Retrieved from the Internet: URL:http://docs.oracle.com/cd/E19088-01/v4 40.srvr/819-2290-10/819-2290-10.pdf [retrieved on 2014-02-14]

## Description

### FIELD OF THE INVENTION

The present invention relates to an adjustment device for a cable management arm, and more particularly, to a length-extendable adjustment device for a cable management arm, and the adjustment device has positioning features.

### BACKGROUND OF THE INVENTION

U.S. Patent No. 7,472,795 B2 to Dubon et al., U.S. Patent No. 7,654,398 B2 to Bridges et al., U.S. Patent No. 7,746,667 B1 to Baiza et al., and U.S. Patent No. 7,554,819 B2, U.S. Patent No. 7,712,615 B2, U.S. Patent No. 8,231,014 B2 and U.S. Patent No. 8,251,321 B2 to Chen et al., disclose different cable management arms. Cable management arms being length-extendable are also known from the prior art. The present invention intends to provide an adjustment device for a cable management arm, wherein the length of the adjustment device is easily extendable relative to the rack so as to make the cable management arm be adapted to manage the cables of each of various chasses which is installed to the rack.

### SUMMARY OF THE INVENTION

The present invention relates to an adjustment device for a cable management arm according to claim 1. Preferably, the first support member has an end wall and a side wall which is substantially perpendicular and connected to the end wall. The plurality of holes are located on the side wall.

Preferably, the second support member has a support plate having two bent portions. The two bent portions define a path. The first support member is inserted into the path of the second support member. The second support member is linearly movable relative to the first support member by the bent portions.

Preferably, the positioning member comprises two positioning portions and two resilient sections.

Alternatively, the present invention also provides a cable management arm installed to a rack. The rack at least comprises two first posts and two second posts. Wherein, one of two slide assemblies is connected between the two first posts, while the other one is connected between the two second posts. The cable management arm comprises a first adjustment device, a second adjustment device, and an arm connected between the first and second adjustment devices. At least one of the first and second adjustment devices comprises a first support member having an end wall and a side wall substantially perpendicular and connected to the end wall. The end wall is installed to the rack. The side wall has a plurality of holes. A second support member is movably connected to the first support member and has a through hole. A positioning member is fixed to the second support member and has a positioning portion and a resilient section connected to the positioning portion. The positioning portion partially extends through the through hole of the second support member, selectively extends through one of the holes of the first support member, and then is positioned by a force of the resilient section, such that the extension-length of the second support member relative to the first support member is adjusted.

Preferably, a pivoting member is pivotably connected to the second support member and the arm.

Preferably, the pivoting member has a pivot and a handle which is substantially perpendicular and connected to the pivot.

Preferably, the positioning member comprises an operation portion and a connection section connected to the operation portion. The operation portion extends an upward angle relative to the connection section. The connection section is connected to one of the positioning portion and the resilient section.

Preferably, the operation portion is located away from a fixed point (i.e. where the fulcrum formed) of the positioning member. The positioning portion is located between the operation portion and the resilient section.

The present invention will become more obvious from the following description when taken in connection with the accompanying drawings which show, for purposes of illustration only, a preferred embodiment in accordance with the present invention.

### BRIEF DESCRIPTION OF THE DRAWINGS

FIG. 1 is a schematic view to show that the cable management arm and two slide assemblies in accordance with the preferred embodiment of the present invention are installed to the rack;
FIG. 2A is an exploded view to show the adjustment device of the cable management arm in accordance with the preferred embodiment of the present invention;
FIG. 2B is a perspective view to show the second support member of the cable management arm in accordance with the preferred embodiment of the present invention;
FIG. 3 is a schematic view to show that the cable management arm in accordance with the preferred embodiment of the present invention is installed to a rack;
FIG. 4A is a schematic view to show that the adjustment device of the cable management arm in accordance with the preferred embodiment of the present invention is in a positioned status;
FIG. 4B is a schematic view to show the operation to the adjustment device of the cable management arm in accordance with the preferred embodiment of the present invention;
FIG. 4C is a schematic view to show the movement of the adjustment device of the cable management arm in accordance with the preferred embodiment of the present invention;
FIG. 5A is a schematic view to show that the arm of the cable management arm in accordance with the preferred embodiment of the present invention is pivotably connected to the second support member by a removable pivoting member;
FIG. 5B is a schematic view to show the removable pivoting member being removed from the arm of the cable management arm in accordance with the preferred embodiment of the present invention;
FIG. 5C is a schematic view to show that the arm of the cable management arm in accordance with the preferred embodiment of the present invention is separated from the second support member;
FIG. 6 is a schematic view to show the positioning member in accordance with the second embodiment of the present invention; and
FIG. 7 is a schematic view to show the positioning member in accordance with the third embodiment of the present invention.

### DETAILED DESCRIPTION OF THE PREFERRED EMBODIMENT

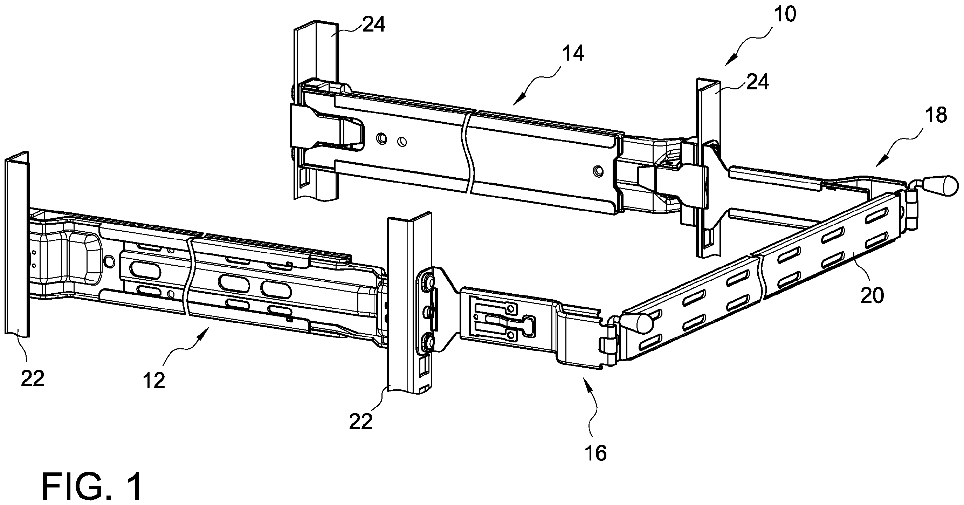

Referring to FIG. 1, a preferred embodiment of the present invention comprises a rack 10, a first slide assembly 12, a second slide assembly 14, a first adjustment device 16, a second adjustment device 18, and an arm 20. The rack 10 comprises two first posts 22 and two second posts 24 located correspondingly. The first slide assembly 12 is connected between the two first posts 22. The second slide assembly 14 is connected between the two second posts 24. The first adjustment device 16 is installed to one of the two first posts 22 of the rack 10, and the second adjustment device 18 is installed to one of the two second posts 24 of the rack 10. The first adjustment device 16 and the second adjustment device 18 are located correspondingly. The arm 20 is connected between the first and second adjustment devices 16, 18.

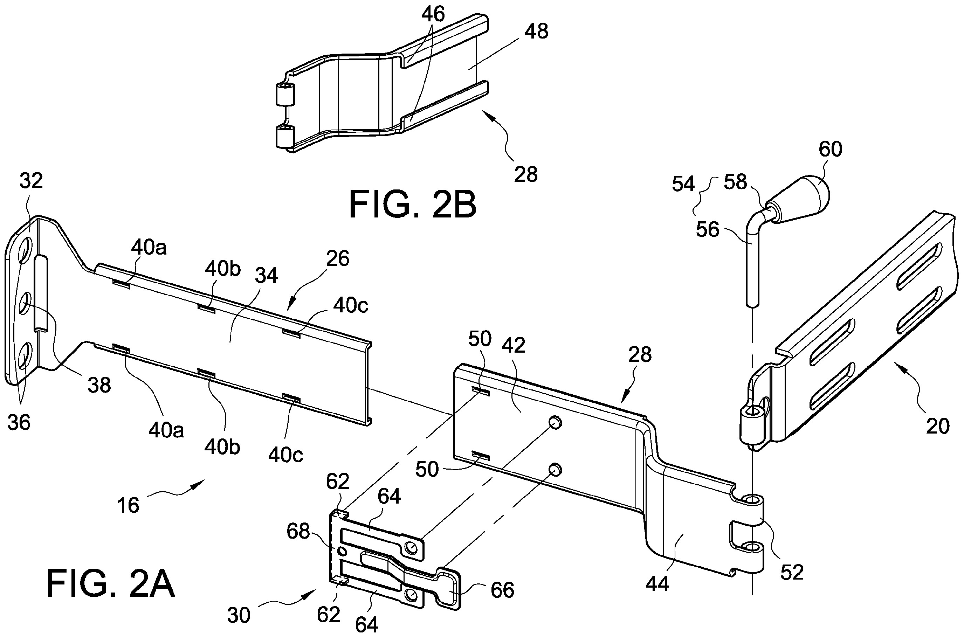

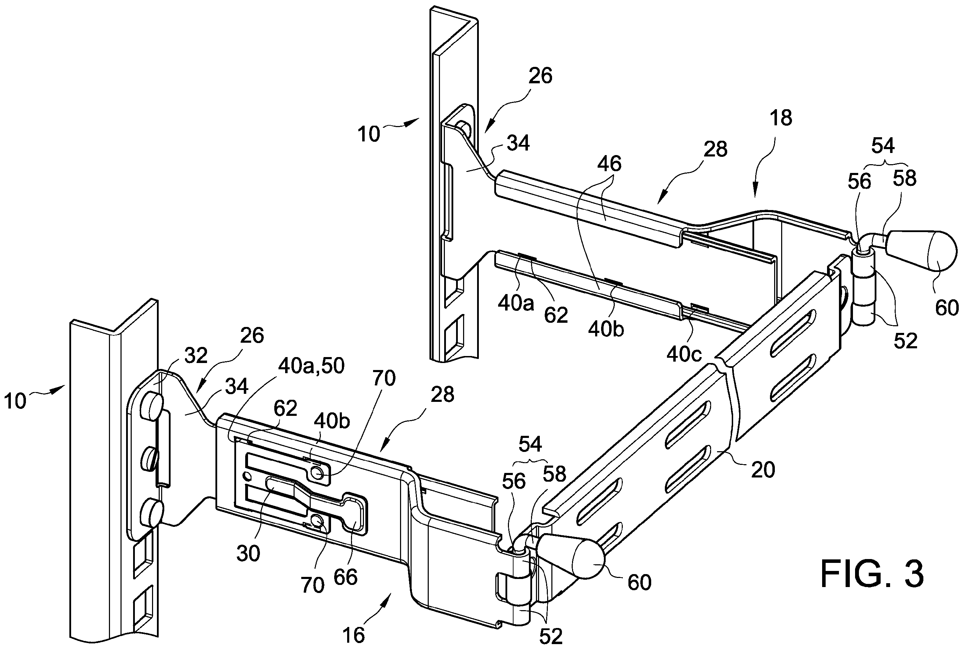

FIGS. 2A, 2B, and 3 show the structures of the first and second adjustment devices 16, 18. In a preferred embodiment of the present invention, the first and second adjustment devices 16, 18 have the same structure and are located symmetrically. Herewith, the first adjustment device 16 is taken in the FIGS for illustration. The first adjustment device 16 comprises a first support member 26, a second support member 28, and a positioning member 30, wherein the first support member 26 has an end wall 32 and a side wall 34 substantially perpendicular and connected to the end wall 32. The end wall 32 is removably installed to the rack 10. In a preferred embodiment, the end wall 32 has two installation holes 36 and a locking hole 38, and the side wall 34 has a plurality of holes, at least, including a first hole 40a, a second hole 40b, and a third hole 40c, wherein a distance is formed between any two adjacent holes.

The second support member 28 is movably connected to the first support member 26. The second support member 28 has a support plate 42 and a connection plate 44, which extends at an angle from one end of the support plate 42. The support plate 42 has two bent portions 46, which define a path 48, so that the first support member 26 can be inserted into the path 48 of the second support member 28, and the second support member 28 can be linearly moved relative to the first support member 26 by the bent portions 46. The support plate 42 has at least one through hole 50 so that when the second support member 28 is linearly moved relative to the first support member 26, the through hole 50 is able to be aligned with the first, second and third holes 40a, 40b, 40c in sequence. The connection plate 44 has a pivoting portion 52. A pivoting member 54 is removably and pivotably connected to the pivoting portion 52 of the connection plate 44 of the second support member 28 and the arm 20. In a preferred embodiment, the pivoting member 54 has a pivot 56 and a handle 58, which is substantially perpendicular and connected to the pivot 56. The pivoting member 54 is connected to the pivoting portion 52 of the connection plate 44 and the arm 20 by the pivot 56. By holding the handle 58, a user can remove the pivot 56 of the pivoting member 54 from the pivoting portion 52 of the connection plate 44 and the arm 20. Preferably, a fitting 60 is fitted on the handle 58 to facilitate the operation to the pivoting member 54.

The positioning member 30 is fixed, for example by a rivet, to the second support member 28. The positioning member 30 comprises at least one positioning portion 62 and at least one resilient section 64 connected to the positioning portion 62. The positioning portion 62 partially extends through the through hole 50 of the second support member 28. The positioning member 30 is fixedly connected to the second support member 28 by a portion of the resilient section 64 so as to form a fulcrum 70.

In one preferred embodiment, the positioning member 30 further comprises an operation portion 66 and a connection section 68 connected to the operation portion 66, wherein the operation portion 66 extends an upward angle relative to the connection section 68, so that the user can easily press or pull the operation portion 66. The connection section 68 is connected to one of the positioning portion 62 and the resilient section 64. Preferably, the positioning member 30 comprises two positioning portions 62 and two resilient sections 64, and the connection section 68 is connected between the two positioning portions 62. Similarly, the support plate 42 of the second support member 28 has pairs of the through holes 50. The side wall 34 of the first support member 26 has pairs of the first holes 40a, the second holes 40b, and the third holes 40c. Preferably, the operation portion 66 and the positioning portion 62 as well as the resilient section 64 of the positioning member 30 are located on opposite sides with respect to the fixed point, where the positioning member 30 fixed to the second support member 28.

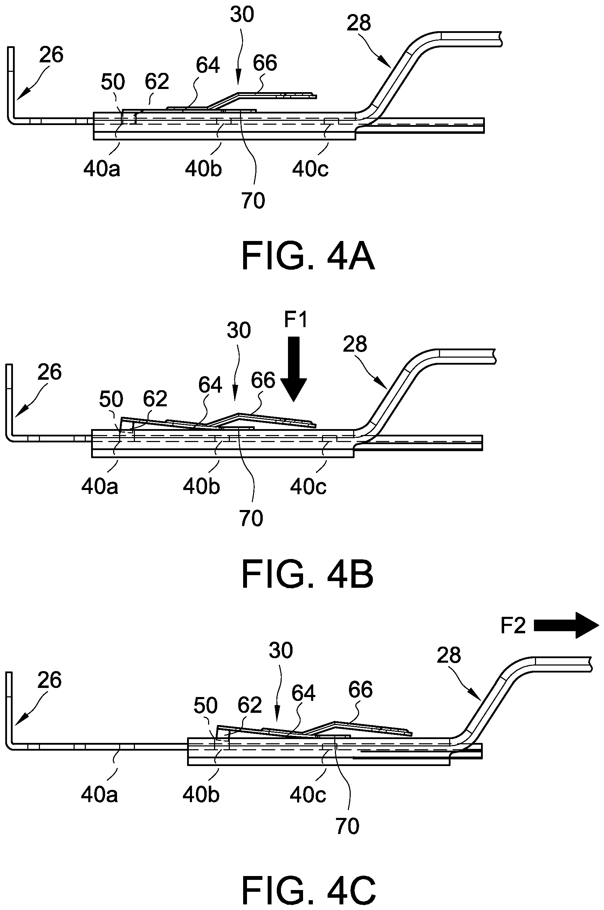

FIGS. 3 and 4A show that the end wall 32 of the first support member 26 is installed to the rack 10. The positioning portion 62 of the positioning member 30 extends through the through hole 50 of the second support member 28 and the first hole 40a of the first support member 26 and then is positioned by a force of the resilient section 64. Therefore, the positioning portion 62 of the positioning member 30 extends through the first hole 40a of the first support member 26 to be positioned.

FIGS. 4B and 4C show that when an external force F1, such as a pressing force, is applied to the operation portion 66 of the positioning member 30, the positioning portion 62 of the positioning member 30 is apart from the through hole 50 of the second support member 28 and the first hole 40a of the first support member 26, such that the extension-length of the second support member 28 relative to the first support member 26 can be adjusted in a direction of F2. Therefore, the positioning portion 62 selectively extends through one of the second and third holes 40b, 40c of the first support member 26 to be positioned.

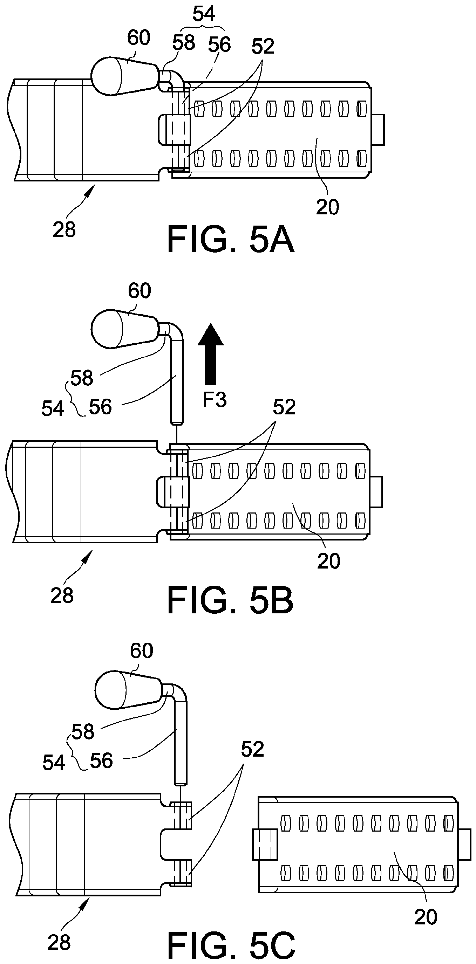

FIGS. 5A to 5C show that the removable pivoting member 54 is connected to the pivoting portion 52 of the connection plate 44 of the second support member 28 and the arm 20. When an external force F3 is applied to the handle 58 of the pivoting member 54, the pivoting member 54 can be easily removed from the pivoting portion 52 of the connection plate 44 of the second support member 28 and the arm 20, so that one end of the arm 20 can be temporarily separated from the second support member 28 to facilitate the maintenance of the servers (not shown) in the rack 10, such as replacement of the power modules or cables.

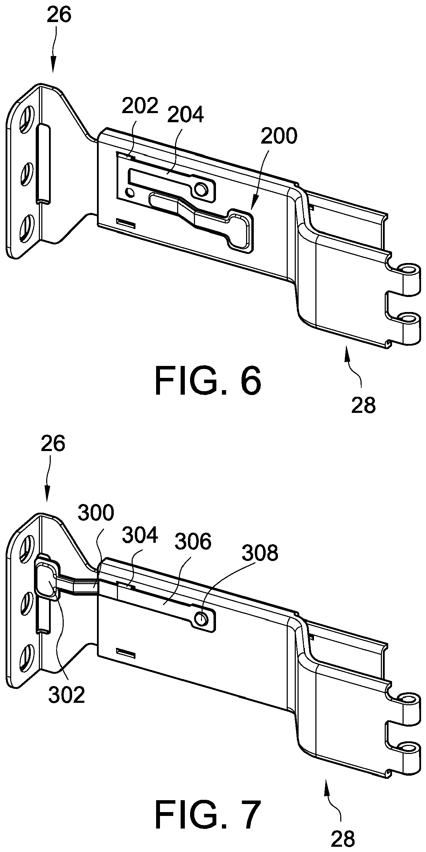

FIG. 6 shows the second preferred embodiment of the present invention, wherein the positioning member 200 has only one positioning portion 202 and one resilient section 204, which can also achieve the same positioning function as that provided in the foregoing embodiment.

FIG. 7 shows the third preferred embodiment, wherein the positioning member 300 has an operation portion 302, a positioning portion 304, and a resilient section 306. The operation portion 302 is located away from a fixed point, where the fulcrum 308 is formed, of the positioning member 300. The positioning portion 304 is located between the operation portion 302 and the resilient section 306 so that the operation portion 302 is operated by a pull.

While we have shown and described the preferred embodiment in accordance with the present invention, it should be clear to those skilled in the art that further embodiments may be made without departing from the scope of the present invention.

## Claims

1. An adjustment device for a cable management arm comprising
a first support member (26) having a plurality of holes (40a-40c) along its length, a second support member (28) movably connected to the first support member (26), the second support member (28) having a through hole (50), **characterized by** a positioning member (30) fixed to the second support member (28) and having a movable positioning portion (62) and a resilient section (64) connected to the positioning portion (62), wherein the positioning portion (62) partially extends through the through hole (50) of the second support member (28) and selectively extends through one of the holes (40a-40c) of the first support member (26), and then is positioned by a force of the resilient section (64), such that an extension-length of the second support member (28) relative to the first support member (26) is adjusted, and wherein the positioning member (30) comprises an operation portion (66) and a connection section (68) connected to the operation portion (66), the operation portion (66) extends an upward angle relative to the connection section (68), the connection section (68) is connected to one of the positioning portion (62) and the resilient section (64), wherein when an external force, such as a pressing force, is applied to the operation portion (66) of the positioning member (30), the positioning portion (62) of the positioning member (30) is apart from the through hole (50) of the second support member (28) and one of the holes (40a-40c) of the first support member (26), such that the extension-length of the second support member (28) relative to the first support member (26) can be adjusted.

2. The adjustment device as claimed in claim 1, wherein the first support member (26) has an end wall (32) and a side wall (34) substantially perpendicular and connected to the end wall (32), the plurality of holes (40a-40c) located on the side wall (34).

3. The adjustment device as claimed in claim 1, wherein the second support member (28) has a support plate (42) having two bent portions (46), the two bent portions (46) define a path (48), the first support member (26) is inserted into the path (48) of the second support member (28), and the second support member (28) is linearly movable relative to the first support member (26) by the bent portions (46).

4. The adjustment device as claimed in claim 1, wherein the positioning member (30) comprises two positioning portions (62) and two resilient sections (64).

5. A cable management arm installed to a rack (10), the rack at least comprising two first posts (22) and two second posts (24), wherein one of two slide assemblies (12, 14) is connected between the two first posts (22), while the other one is connected between the two second posts (24); **characterized in that** the cable management arm comprises a first adjustment device (16), a second adjustment device (18) and an arm (20) connected between the first and second adjustment devices (16, 18), wherein at least one of the first and second adjustment devices (16, 18) is the adjustment device according to claim 2, and the end wall (32) is installed to the rack (10).

6. The cable management arm as claimed in claim 5, further comprising a pivoting member (54) pivotably connected to the second support member (28) and the arm (20).

7. The cable management arm as claimed in claim 6, wherein the pivoting member (54) has a pivot (56) and a handle (58) substantially perpendicular and connected to the pivot (56).

8. The cable management arm as claimed in claim 5, wherein the positioning member (30) comprises an operation portion (66) and a connection section (68) connected to the operation portion (66), the operation portion (66) extending an upward angle relative to the connection section (68), the connection section (68) connected to one of the positioning portion (62) and the resilient section (64).

9. The cable management arm as claimed in claim 8, wherein the operation portion (302) is located away from a fixed point (308) of the positioning member (300), and the positioning portion (304) is located between the operation portion (302) and the resilient section (306).

## Patentansprüche

1. Ein Justiergerät für einen Kabelhaltearm, umfassend
ein erstes Stützglied (26) mit mehreren Löchern (40a-40c) an dessen Länge entlang; ein zweites Stützglied (28), das beweglich am ersten Stützglied (26) montiert ist; das zweite Stützglied (28) ein Durchgangsloch (50) aufweist, **dadurch gekennzeichnet, dass** ein Positionierglied (30) am zweiten Stützglied (28) befestigt ist und einen beweglichen Positionierteil (62) und einen federnden Bereich (64), der mit dem Positionierteil (62) verbunden ist, aufweist; wobei der Positionierteil (62) teilweise durch das Durchgangsloch (50) des zweiten Stützglieds (28) und wahlweise durch eines der Löcher (40a-40c) des ersten Stützglied (26) ragt, wonach der Positionierteil (62) mit einer Kraft des federnden Bereichs (64) so positioniert wird, dass eine Auszugslänge des zweiten Stützglieds (28) relativ zum ersten Stützglied (26) justiert wird; wobei das Positionierglied (30) einen Betätigungsteil (66) und einen Verbindungsteil (68), der am Betätigungsteil (66) befestigt ist, umfasst; der Betätigungsteil (66) sich aufwärts in einem Winkel relativ zum Verbindungsteil (68) erstreckt; der Verbindungsteil (68) an einem der Positionierteile (62) des federnden Bereichs (64) befestigt ist;
beim Ausüben einer äußeren Kraft, beispielsweise einer Presskraft, auf den Betätigungsteil (66) des Positionierglieds (30) das Positionierteil (62) des Positionierglieds (30) weg vom Durchgangsloch (50) des zweiten Stützglieds (28) und einem der Löcher (40a-40c) des ersten Stützglieds (26) ist, so dass die Auszugslänge des zweiten Stützglieds (28) relativ zum ersten Stützglied (26) justiert werden kann.

2. Das Justiergerät nach Anspruch 1, wobei das erste Stützglied (26) mit einer Stirnwand (32) und einer Seitenwand (34), die im Wesentlichen senkrecht zur Stirnwand (32) angeordnet und mit dieser verbunden ist, ausgebildet ist; die mehreren Löcher (40a-40c) in der Seitenwand (34) gebildet sind.

3. Das Justiergerät nach Anspruch 1, wobei das zweite Stützglied (28) eine Trägerplatte (42) mit zwei gebogenen Teilen (46) aufweist; die beiden gebogenen Teile (46) einen Pfad (48) bilden; das erste Stützglied (26) in den Pfad (48) des zweiten Stützglieds (28) eingeführt ist; das zweite Stützglied (28) mit den gebogenen Teilen (46) relativ zum ersten Stützglied (26) linear beweglich ist.

4. Das Justiergerät nach Anspruch 1, wobei das Positionierglied (30) zwei Positionierteile (62) und zwei federnde Bereiche (64) umfasst.

5. Ein an einem Gestell (10) montierten Kabelhaltearm, wobei das Gestell (10) mindestens zwei erste Stangen (22) und zwei zweite Stangen (24) umfasst, wobei einer der beiden Schlitten (12, 14) zwischen den zwei ersten Stangen (22) und der andere zwischen den beiden zweiten Stangen (24) montiert ist; **dadurch gekennzeichnet, dass** der Kabelhaltearm ein erstes Justiergerät (16), ein zweites Justiergerät (18) und einen Arm (20), der zwischen dem ersten und zweiten Justiergeräten (16, 18) montiert ist, umfasst, wobei mindestens eines der ersten und zweiten Justiergeräte (16, 18) als das Justiergerät nach Anspruch 2 ausgebildet und die Stirnwand (32) am Gestell (10) montiert ist.

6. Der Kabelhaltearm nach Anspruch 5, weiter umfassend ein schwenkbares Glied (54), das drehgelenkig am zweiten Stützglied (28) und am Arm (20) montiert ist.

7. Der Kabelhaltearm nach Anspruch 6, wobei das schwenkbare Glied (54) einen Drehpunkt (56) und einen Griff (58) aufweist, wobei letzterer im Wesentlichen senkrecht am Drehpunkt (56) befestigt ist.

8. Der Kabelhaltearm nach Anspruch 5, wobei das Positionierglied (30) einen Betätigungsteil (66) und einen Verbindungsteil (68), der am Betätigungsteil (66) montiert ist, umfasst; sich der Betätigungsteil (66) aufwärts in einem Winkel relativ zum Verbindungsteil (68) erstreckt; der Verbindungsteil (68) an einem der Positionierteile (62) und am federnden Bereich (64) montiert ist.

9. Der Kabelhaltearm nach Anspruch 8, wobei der Betätigungsteil (302) weg von einem Festpunkt (308) des Positionierglieds (300) angeordnet ist; der Positionierteil (304) zwischen dem Betätigungsteil (302) und dem federnden Bereich (306) vorgesehen ist.

## Revendications

1. Dispositif réglable pour un bras de gestion des câbles **caractérisé par le fait qu'**il comprend
un premier élément de support (26) présentant une pluralité de trous (40a-40c) sur sa longueur, un second élément de support (28) raccordé de manière mobile au premier élément de support (26), le second élément de support (28) présentant un trou traversant (50), **caractérisé par** un élément de positionnement (30) attaché au second élément de support (28) et présentant une partie de positionnement mobile (62) et une partie résiliente (64) raccordée à la partie de positionnement (62), la partie de positionnement (62) se prolonge partiellement à travers le trou traversant (50) du second élément de support (28) et se prolonge sélectivement à travers l'un des trous (40a-40c) du premier élément de support (26), et est ensuite positionnée par une force de la partie résiliente (64), de sorte qu'une longueur d'extension du second élément de support (28) par rapport au premier élément de support (26) est réglée, et l'élément de positionnement (30) comprend une partie d'actionnement (66) et une section de raccordement (68) raccordée à la partie d'actionnement (66), la partie d'actionnement (66) prolonge un angle ascendant par rapport à la section de raccordement (68), la section de raccordement (68) est raccordée soit à la partie de positionnement (62) ou à la partie résiliente (64),
lorsqu'une force externe, tel une force de compression, est appliquée à la partie d'actionnement (66) de l'élément de positionnement (30), la partie de positionnement (62) de l'élément de positionnement (30) est séparée du trou traversant (50) du second élément de support (28) et de l'un des trous (40a-40c) du premier élément de support (26), de sorte que la longueur d'extension du second élément de support (28) par rapport au premier élément de support (26) peut être réglée.

2. Dispositif réglable selon la revendication 1, **caractérisé par le fait que** le premier élément de support (26) présente une paroi d'extrémité (32) et une paroi latérale (34) sensiblement perpendiculaire et raccordée à la paroi d'extrémité (32), la pluralité de trous (40a-40c) située sur la paroi latérale (34).

3. Dispositif réglable selon la revendication 1, **caractérisé par le fait que** le second élément de support (28) présente une plaque de support (42) présentant deux parties courbées (46), les deux parties courbées (46) définissent une trajectoire (48), le premier élément de support (26) est inséré dans la trajectoire (48) du second élément de support (28), et le second élément de support (28) est mobile de manière linéaire par rapport au premier élément de support (26) par les parties courbées (46).

4. Dispositif réglable selon la revendication 1, **caractérisé par le fait que** l'élément de positionnement (30) comprend deux parties de positionnement (62) et deux parties résilientes (64).

5. Bras de gestion des câbles installé sur un rack (10), le rack **caractérisé par le fait qu'**il comprend au moins deux premiers montants (22) et deux seconds montants (24), l'un de deux ensembles de glissières (12, 14) est raccordé entre les deux premiers montants (22), alors que l'autre est raccordé entre les deux seconds montants (24) ; caractérisé en que le bras de gestion des câbles comprend un premier dispositif réglable (16), un second dispositif réglable (18) et un bras (20) raccordé entre les premier et second dispositifs réglables (16, 18), au moins l'un des premier et second dispositifs réglables (16, 18) est le dispositif réglable selon la revendication 2, et la paroi d'extrémité (32) est installée sur le rack (10).

6. Bras de gestion des câbles selon la revendication 5, **caractérisé par le fait qu'**il comprend en outre un élément pivotant (54) raccordé de manière pivotante au second élément de support (28) et le bras (20).

7. Bras de gestion des câbles selon la revendication 6, **caractérisé par le fait que** l'élément pivotant (54) présente un pivot (56) et une poignée (58) sensiblement perpendiculaire et raccordée au pivot (56).

8. Bras de gestion des câbles selon la revendication 5, **caractérisé par le fait que** l'élément de positionnement (30) comprend une partie d'actionnement (66) et une section de raccordement (68) raccordée à la partie d'actionnement (66), la partie d'actionnement (66) prolongeant un angle ascendant par rapport à la section de raccordement (68), la section de raccordement (68) raccordée soit à la partie de positionnement (62) ou à la partie résiliente (64).

9. Bras de gestion des câbles selon la revendication 8, **caractérisé par le fait que** la partie d'actionnement (302) est située à l'écart d'un point fixe point (308) de l'élément de positionnement (300), et la partie de positionnement (304) est située entre la partie d'actionnement (302) et la partie résiliente (306).
